Europäisches Patentamt

(19) European Patent Office  (11) Publication number: **0 124 181**

Office européen des brevets  **B1**

(12) **EUROPEAN PATENT SPECIFICATION**

(45) Date of publication of patent specification: **16.08.90**  (51) Int. Cl.⁵: **H 01 L 23/52**

(21) Application number: **84200602.5**

(22) Date of filing: **02.05.84**

(54) Semiconductor device comprising a semiconductor body on which conductive tracks are disposed which are interconnected through a window in an insulating layer and method manufacturing same.

(30) Priority: **02.05.83 US 490381**

(43) Date of publication of application:
**07.11.84 Bulletin 84/45**

(45) Publication of the grant of the patent:
**16.08.90 Bulletin 90/33**

(84) Designated Contracting States:
**DE FR GB IT NL**

(56) References cited:
**EP-A-0 002 185**
**GB-A-1 604 074**
**US-A-3 477 872**

**PATENTS ABSTRACTS OF JAPAN, vol. 6, no.
254 (E-148) 1132r, 14th December 1982; & JP - A
- 57 153 447**

(73) Proprietor: **N.V. Philips' Gloeilampenfabrieken
Groenewoudseweg 1
NL-5621 BA Eindhoven (NL)**

(72) Inventor: **Broadbent, Eliot Kent
c/o INT. OCTROOIBUREAU B.V. Prof. Holstlaan 6
NL-5656 AA Eindhoven (NL)**

(74) Representative: **Rensen, Jan Geert et al
Internationaal Octrooibureau B.V. Prof.
Holstlaan 6
NL-5656 AA Eindhoven (NL)**

## Description

Semiconductor device comprising a semiconductor body on which semiconductor tracks are disposed which are interconnected through a window in an insulating layer and method of manufacturing same.

The invention relates to a semiconductor device comprising a semiconductor body which is provided with a surface which is covered by a first insulating layer on which a first conductive track is disposed which is covered by a second insulating layer, which extends also over the first insulating layer and on which a second conductive track is disposed, the second insulating layer being provided with a window through which the second conductive track contacts the first conductive track, while a tungsten layer is present under the second conductive track. The invention further relates to a method of manufacturing such a device.

The Japanese Patent Application KOKAI Nr. 52—149990 discloses a device of the kind mentioned in the opening paragraph, in which tungsten is present under the whole area of the second conductive track. This device is manufactured by starting from a semiconductor body having a surface provided with a first insulating layer and by providing on this layer in order of succession a first conductive track and a second insulating layer having a window, through which a part of the first track is exposed. Subsequently, the whole is covered by a layer of tungsten and a conductive layer into which a second conductive track is etched, which contacts the first conductive track through the window in the second insulating layer. The tungsten layer then acts as an etching stop, as a result of which the first conductive track is prevented from being damaged during etching. After the second conductive track has been etched, whilst using the said second track, the tungsten then exposed is removed. Thus, a tungsten layer is present at the whole area under the second conductive track, also at the area at which the second track contacts the first track.

A disadvantage of the known semiconductor device described is that during operation of the device, short-circuits may occur between initially normally insulated conductive tracks.

The invention has *inter alia* for its object to provide, whilst using a tungsten layer as an etching stop for patterning by etching the second conductive layer, a device, in which the occurrence of shortcircuits between initially mutually insulated conductive tracks is avoided to a great extent.

The invention is based on the recognition of the fact that the said shortcircuits are caused by monocrystalline whiskers which can grow from the second conductive layer in the presence of an adjoining layer of tungsten. This occurs especially if the second conductive layer is made of aluminium.

According to the invention, this object is achieved in the semiconductor device of the kind mentioned in the opening paragraph in that the tungsten is present only at the area of the first conductive track within the window in the second insulating layer. The said growth of whiskers can now occur only within the window in the second insulating layer, but the said shortcircuit between initially mutually insulated conductive tracks no longer occurs.

The invention further relates to a method of manufacturing a device of the kind mentioned in the opening paragraph, in which there are provided on a surface of a semiconductor body provided with a first insulating layer in order of succession a first conductive track, a second insulating layer with a window, through which a part of the first conductive track is exposed, a layer of tungsten and a second conductive layer, after which a second conductive track contacting the first conductive track is etched into the second conductive layer. According to the invention, this method is characterized in that the layer of tungsten is deposited selectively on the exposed part of the first conductive track. Thus, it is achieved in a very practical manner that in the device tungsten is present only at the area of the first conductive track within the window in the second insulating layer. Thus, the tungsten can act as an etching stop when the second conductive layer is patterned by etching, as a result of which the first conductive track is protected. Tungsten which then remains need not be removed because it is present only within the window in the second insulating layer.

A preferred embodiment of the method according to the invention is characterized in that the first and the second insulating layer are made of silicon oxide or silcion nitride and the first conductive track is made of aluminium containing no more than 4% by weight of copper and no more than 4% by weight of silicon or of polycrystalline silicon to which a dopant may be added. Due to this practical choice of materials it is possible to etch the conductive tracks, the subjacent layers (silicon oxide or silicon nitride for the first track and silicon oxide or silicon nitride and tungsten for the second track) being substantially not attacked.

Preferably, tungsten is deposited from a reaction gas comprising tungsten hexafluoride and hydrogen which is passed at a pressure of less than 650 Pa over the semiconductor body heated to a temperature of 270 to 400°C. In the case in which the first conductive track is made of aluminium, hydrogen is absorbed at the exposed aluminium and is then dissociated, as a result of which tungsten can adhere to the surface. In the case in which the first conductive track is made of polycrystalline silicon, tungsten hexafluoride is reduced by silicon so that a very thin layer of polycrystalline silicon is exchanged for a very thin layer of tungsten. In both cases, additional tungsten formed by hydrogen reduction of tungsten haxafluoride grows on the very thin layer of tungsten. The reactions described do not or substantially not occur at the surfaces of silicon oxide or silicon nitride.

If nevertheless some tungsten should grow on the insulating layers, the thickness thereof as compared with the thickness of the tungsten grown on the first conductive track is so small and moreover its adherence is so low that this tungsten can be readily removed by a cleaning operation.

The invention will now be described more fully, by way of example, with reference to the accompanying drawing, in which:

Figures 1a, 2a, 3a, 4a, 5a and 6a show in cross-section successive stages in the manufacture of a semiconductor device according to the invention (Figures 1a—6a are cross-sections taken on the planes 1a—1a, 2a—2a, 3a—3a, 4a—4a, 5a—5a and 6a—6a, respectively, in Figures 1b—6b);

Figures 1b—6b are cross-sections taken on the planes 1b—1b, 2b—2b, 3b—3b, 4b—4b, 5b—5b and 6b—6b, respectively, in Figures 1a—6a;

Fig. 3c is a plan view of the semiconductor device shown in Figures 3a and 3b;

Fig. 5c is a plan view of the semiconductor device shown in Figures 5a and 5b (for the sake of clarity, Figures 3c and 5c are cross-hatched according to the same standard as Figures 1a—6a and 1b—6b, although Figures 3c and 5c are no cross-sections);

Fig. 7 shows diagrammatically a chemical deposition apparatus suitable for use in the manufacture of the semiconductor device.

Like reference symbols are employed in the drawings and in the description of the preferred embodiments to represent the same or very similar item or items.

Referring to the drawings, Figs. 1a—6a, 1b—6b, 3c and 5c illustrate steps in fabricating a semiconductor device according to a process involving selective tungsten deposition. In this process, all photoresist masks are formed according to contventioal photolithographic techniques. The resin frequency (RF) level for all plasma etchings is 13.5 megahertz.

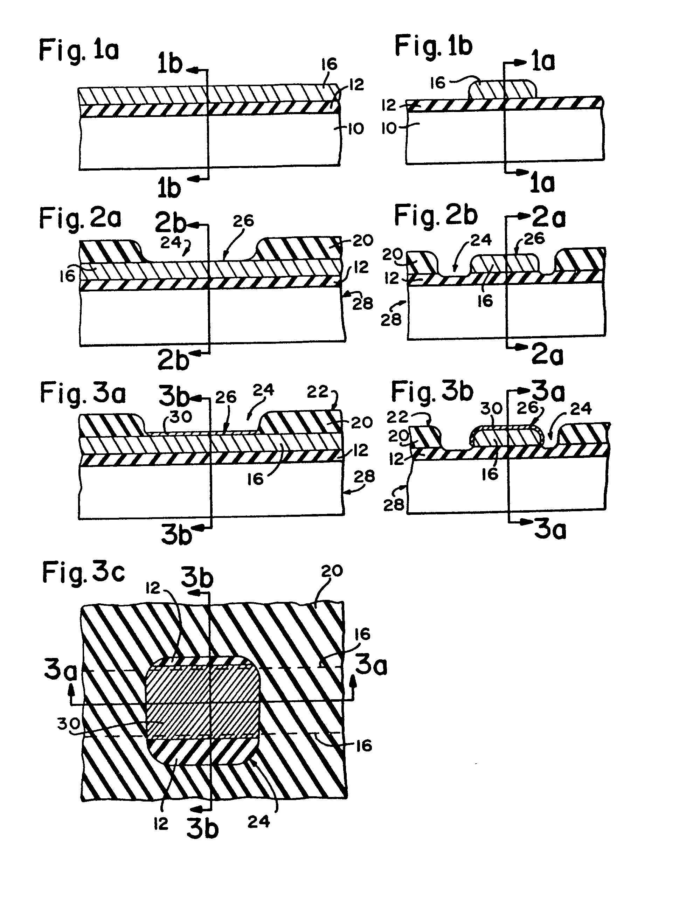

The starting material is a monocrystalline silicon semiconductor body 10 as indicated in Figs. 1a and 1b. Body 10 may consist simply of a P-type or N-type doped substrate or of such a substrate with an epitaxial layer grown on it. Various N-type and P-type doped regions (not shown in the drawings) normally exist in body 10.

A first electrically insulating layer 12 of silicon dioxide lies on the upper surface of body 10. Insulating layer 12 is preferably grown according to conventional thermal oxidation techniques to a thickness of about 4,000 angstroms along the top of body 10. Layer 12 could also be formed by depositing $SiO_2$ on the top of body 10.

A first patterned electrically conductive layer 16 is defined on insulating layer 12 by sputter depositing a layer of aluminum with up to 4% copper by weight and/or up to 4% silicon by weight to a thickness of about 6,000 angstroms =(600 nm) on the entire upper surface of layer 12, forming an appropriate photoresist mask (not shown) on top of the deposited layer, and then removing the undesired portions of the deposited layer with a suitable etchant that does not significantly attack layer 12. The etching is preferably performed at 100°C for 5 minutes at a pressure of about 0.01 torr =(1 Pa) with a plasma consisting of equal parts by input volume of boron trichloride and chlorine in a system operating at 1,000 watts of RF power. Layer 16 is a conductive track having a width of about 4 microns ($\mu$m) and an orientation perpendicular to Fig. 1b. Optimally, layer 16 is Al with about 1% Cu.

After removing the photoresist mask, a second electrically insulating layer 20 is deposited on conductive layer 16 and on the exposed adjacent portions of insulating layer 12. Insulating layer 20 preferably consists of silicon nitride deposited according to conventional plasma deposition techniques to a thickness of about 7,000 angstroms (700 nm).

A window (or via) 24 about 7 microns ($\mu$m), by 7 microns ($\mu$m) in area is created through insulating layer 22 down to a surface portion 26 of conductive layer 16 to produce the structure indicated by symbol 28 in Figs. 2a and 2b. In particular, an appropriate photoresist mask (not shown) is formed on the top of the structure after which layer 20 is etched through with a suitable etchant that does not significantly attack conductive layer 16. This etching is preferably done at 130°C for 5 minutes at a pressure of about 0.7 torr =(90 Pa) with a plasma consisting of 4 parts by input volume of sulfur hexafluoride to 1 part of oxygen in a system operating at 200 watts of RF power.

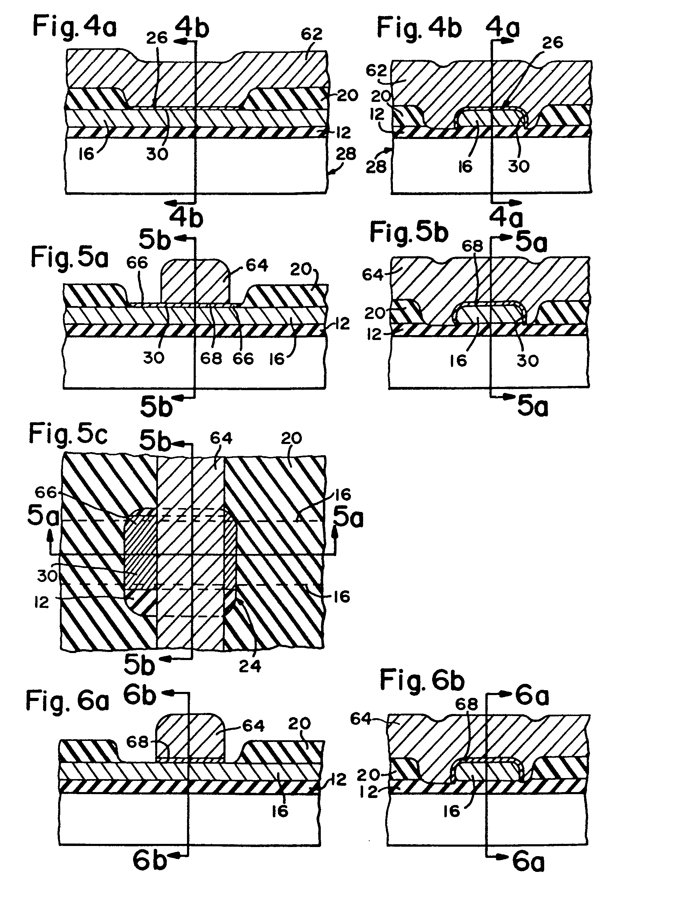

As shown in Fig. 2b, aperture 24 is an oversize window in that it extends laterally beyond the side edges of conductive layer 16. This makes registration of the photoresist mask used in defining aperture 24 "non-critical" as indicated by the slight misalignment of line 16 relative to aperture 24 in Fig. 2b and the corresponding slight misalignment illustrated later in Fig. 5a. As further shown in Fig. 2b, aperture 24 also extends slightly into insulating layer 12. However, this is not necessary. In fact, aperture 24 need not extend all the way through layer 20 on the sides of layer 16. Nor is it necessary that the side edges of layer 16 be exposed. That is, aperture 24 need only expose part of the actual top of layer 16.

After removing the photoresist mask, resulting structure 28 is carefully precleaned to remove contaminants including organic matter, dust, and particulates. In this precleaning operation, structure 28 is first placed in a bath of 10 parts by weight of sulfuric acid to 1 part of hydrogen peroxide for 10 minutes at 100°C after which structure 28 is rinsed in deionized water for 10 minutes and spun dry for 6 minutes. Structure 28 is then treated at 100°C for 2 minutes at a pressure of about 0.5 torr =(65 Pa) in a plasma consisting of 9 parts by input volume of oxygen to 1 part of carbon tetrafluoride at 275 watts of RF power. Finally, structure 28 is placed in a bath of 100 parts by weight of water to 1 part of hydrofluoric acid for 30 seconds at room temperature after which structure 28 is rinsed in deionized water for 10 minutes and spun dry for 6 minutes.

Next, tungsten is deposited on exposed portion 26 of the track 16 to form an intermediate electrically conductive layer 30 having a thickness of about 1,500 angstroms (150 nm) as shown in Figs. 3a—3c. Tungsten layer 30 entirely surrounds portion 26 as indicated in Fig. 3b. The tungsten deposition is performed in such a manner that less than one monolayer (i.e., less than $10^{15}$ atoms/cm$^2$) of tungsten simultaneously accrues on the exposed portions of insulating layer 12 adjacent to surface portion 26 or on nearby exposed portions of insulating layer 20. This W thickness on layers 12 and 20 is so small as to be electrically inconsequential—i.e., it will not conduct sufficient (if any) electricity to effect the electrical characteristics of the final electrical interconnection structure.

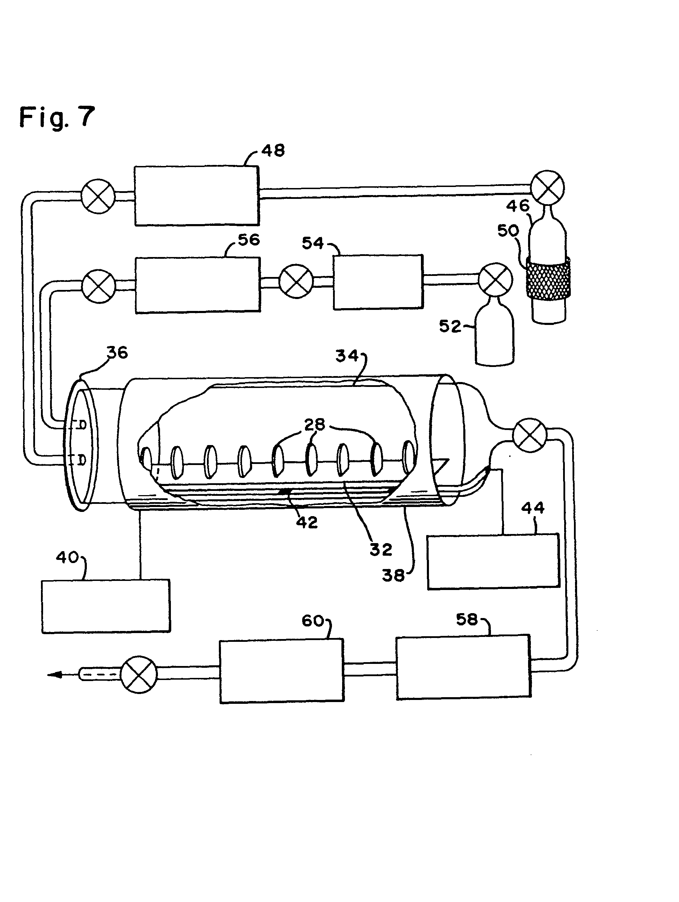

More particularly, W layer 30 is created by low pressure CVD in which tungsten is provided from gaseous tungsten hexafluoride by reducing it in a hydrogen environment near surface portion 26 using an apparatus such as that shown in Fig. 7. In this operation, partially finished structure 28 and other such structures (sometimes simply referred to as substrates) are loaded edgewise onto a substrate holder 32 which is inserted into a quartz tube reaction chamber 34. Its sealing door 36 is then closed to seal off chamber 34. A resistance-heated furnace chamber 38 provides heat to chamber 34. Furnace chamber 38 encloses the portion of reaction chamber 34 where structures 28 are placed and is regulated with a temperature controller 40. The temperature in chamber 34 is determined by a chromeal-alumel thermocouple 42 located in close proximity to holder 32 and connected to an external temperature display 44.

Tungsten hexafluoride is provided to chamber 34 from a WF$_6$ liquid source bottle 46 by way of a WF$_6$ supply line through an automatic flow controller 48 to an inlet part on sealing door 36. A heating jacket 50 on source bottle 46 heats the tungsten hexafluoride slightly above its vaporization temperature. Hydrogen is provided to chamber 34 from an H$_2$ gas source bottle 52 by way of an H$_2$ supply line through a palladium diffusion hydrogen purifier 54 and another automatic flow controller 56 to another inlet port on door 36. Suitable valves along the WF$_6$ and H$_2$ supply lines control the transmission of WF$_6$ and H$_2$ from bottles 46 and 52 to chamber 34.

The pressure in chamber 34 is reduced to a low level by a series combination of a Roots blower vacuum pump 58 and a mechanical rotary-vane vacuum pump 60. Blower pump 58 is connected by way of one part of an evacuation line to the end of chamber 34 opposite door 36, while mechanical pump 60 exhausts through another part of the evacuation line to the atmosphere. Suitable valves along the evacuation line further control the transmission of gases to and from chamber 34.

In performing the selective tungstens deposition, chamber 34 is first evacuated to a pressure of less than 0.05 torr=(6 Pa). Structures 28 are then heated to a temperature in the range of 270°C to 400°C and preferably in the range of 270°C to 350°C. The structure (or deposition) temperature is optimally 300°C. During the period in which structures 28 rise to the desired temperature, chamber 34 is purged with H$_2$ supplied from source bottle 52. The purge could also be done with an inert gas such as argon or nitrogen provided from an external source. During purging, the pressure in chamber 34 rises to about 0.1 to 1 torr=(13 to 130 Pa) and is typically about 0.3 torr=(40 Pa). The purge is stopped when structures 28 reach the desired temperature in the foregoing range. Chamber 34 is re-evacuated to a presusre of less than 0.05 torr=(6 Pa).

Metered quantities of WF$_6$ and H$_2$ regulated by controllers 48 and 56 are now introduced into chamber 34 until W layer 30 reaches the desired thickness. The WF$_6$ flow rate should be no more than 8,000 standard cm$^3$/minute and is preferably 1,500 standard cm$^3$/minute. The H$_2$ flow rate should be no more than 1,000 standard cm$^3$/minute and is preferably 200 standard cm$^3$/minute. To achieve the foregoing thickness of about 1,500 angstroms (150 nm) for layer 30, the WF$_6$ and H$_2$ flows to chamber 34 continue for about 30 minutes. During this period, the hydrogen reduces the tungsten hexafluoride on surface portion 26 so as to free the tungsten and allow it to absorb there and create layer 30.

The W deposition pressure is 5 torr or less. Above this level, the flow in chamber 34 would be viscous, causing the concentrations of the reactant species to vary throughout chamber 34 so as to make the W deposition on structures 28 nonuniform. That is, the thickness of W layer 30 would vary from structure 28 to structure 28 and from point to point on any structure 28. In addition, there would be marked ablation of insulating layers 12 and 20. The deposition pressure in chamber 34 is preferably 1 torr=(130 Pa) of less at which consistent molecular flow occurs. This causes W layer 30 to be of relatively uniform thickness throughout chamber 34. The deposition pressure is typically 0.5 torr=(65 Pa). The minimum deposition pressure is 0.05 to 0.3 torr=(6 to 40 Pa) depending on the gas flow rates and the pumping capability of the evacuation system.

The W deposition proceeds according to the reaction

$$WF_6 + 3H_2 \rightarrow W + 6HF$$

This reaction is surface controlled under the preceding deposition conditions. With reference to Figs. 3a-3c, the rate-limiting mechanism is the dissociation of hydrogen at surface portion 26 and at the exposed areas of insulating layers 12 and 20 so as to enable monatomic hydrogen to react with WF$_6$. With structure 28 pretreated as described above, the structure temperature of 400°C is roughly the dividing line at which conductive layer 16 supports substantial H$_2$ dissociation at surface portion 26 while layers 12 and 20 do not support significant H$_2$ dissociation at their exposed areas. Above this value, the control over selectivity between layer 16 and layers 12 and 20 rapidly diminishes. At 350°C or less, there is sufficient difference between the capability of layer 16 to cause substantial $H_2$ dissociation at surface portion 26 and the inability of layers 12 and 20 to cause significant $H_2$ dissociation at their exposed areas that the thickness of W layer 30 can be readily controlled whereas only an electrically unconsequential amount of tungsten simultaneously accrues on layers 12 and 20. 270°C is the minimum structure temperature at which W deposition begins to occur essentially instantaneously on surface portion 26.

The capability of a surface to sustain $H_2$ dissociation increases with surface non-cleanliness—i.e., organic residues, dust, and particulates. The selectivity difference between surface portion 26 and the exposed areas of insulating layers 12 and 20 diminishes rapidly as these surfaces all become progressively dirtier. The preclean operation performed before structure 28 is placed in chamber 34 in combination with the subsequent purge thus inhibits W deposition on the exposed areas of layers 12 and 20 so as to enhance the selectivity mechanism.

Because of the low deposition pressure and the low surface concentration of the hydrogen fluoride produced in the reduction reaction, no significant ablation of either insulating layer 12 or 20 occurs during the W deposition. Typically, less than 20 angstroms (2 nm) in thickness of a portion of layer 12 or 20 very close to W layer 30 is eroded away. For a portion of layer 12 or 20 not close to layer 30, less than 5 angstroms (0.5 nm) in thickness is typically eroded away.

After removing structure 28 from chamber 34, a cleaning step is typically performed to remove any tungsten that may have accumulated on insulating layers 12 and 20. This cleaning does not substantially affect the thickness of W payer 30. The cleaning is preferably done at 18°C—22°C for 5 minutes with $H_2O_2$, resulting in an etch rate of about 40 angstroms/minute (4 nm/minute).

As shown in Figs. 4a and 4b, an electrically conductive layer 62 of aluminum with up to 4% Cu by weight and/or up to 4% Si by weight is sputter deposited to a thickness of about 15,000 angstroms (1500 nm) on the exposed upper surface of the resulting structure—i.e., on W layer 30 and on the exposed areas of insulating layers 12 and 20. Conductive layer 62 is optimally Al with about 1% Cu.

Conductive layer 62 is now patterned in such a manner that a part of the resulting second patterned conductive layer 64 is in contact with a part of W layer 30 as indicated in Figs. 5a-5c. This patterning is performed by creating an appropriate photoresist mask (not shown) on conductive layer 62 and then removing the undesired portions of layer 62 with a suitable etchant that does not significantly attack tungsten or the material of insulating layers 12 and 20. The etching is preferably done at 100°C for 12 minutes at a pressure of about 0.01 torr=(1 Pa) with a plasma consisting of equal parts by input volume of $BCl_3$ and $Cl_2$ at 1,000 watts of RF power. Resulting patterned layer 64 is a conductive line having a width of about 4 microns (4 μm) oriented perpendicular to conductive line 16. Since aperture 24 is wider than conductive line 64, this patterning exposes portions 66 of layer 30. Inasmuch as the etchant used in this patterning does not attack tungsten to any significant degree, portions 66 act as an etch stop to avoid damage to the underlying portion of conductive layer 16. In short, layer 30 (in combination with insulating layers 12 and 20) prevents undesired open circuiting of line 16.

The electrical interconnection structure may now be finished in a conventional manner. Typically a $Si_3N_4$ layer (not shown) is deposited on the top of the structure. Openings are then created in this layer for an external lead pattern after which the structure is suitable packaged.

Before finishing the structure in this manner, W portions 66 may optionally be removed by etching with an etchant that does not significantly attack insulating layers 12 and 20 or conductive layers 16 and 64. This etching is preferably performed with $H_2O_2$ for 40 mintues at 18°C—22°C. In this etching, conductive layer 64 serves as a mask to prevent any significant etching of underlying tungsten portion 68. The structure may now be finished in the conventional manner described above.

Other dielectrics which (when suitably clean) do not support significant $H_2$ dissociation at a structure temperature of 400°C or less and preferably 350°C or less could be used in place of $SiO_2$ in layer 12 or $Si_3N_4$ in layer 20.

Suitable alternative conductors include titanium, titaniumtungsten, molybdenum, chromium, gold, and various metal silicides including platinum silicide, nickel silicide, nickel-platinum silicide, and palladium silicide. Depending on the alternative material chosen, chemical reactions different from those described above might have to be employed in some of the steps. The foregoing materials could also be used in conductive layer 64.

Conductive layer 16 may also consist of doped polycrystalline silicon. In this case, layer 16 could be created by depositing a layer of polycrystalline silicon doped with a suitable N-type or P-type impurity and then suitably patterning the deposited layer. Alternatively, layer 16 could be created by depositing a layer of substantially intrinsic (i.e., undoped) polycrystalline silicon and then doping this layer with a suitable impurity before or after patterning. Layer 64 could also consist of doped polycrystalline silicon formed in one of the foregoing ways.

If layer 16 is foremd from doped polycrystalline silicon, there is a slight change in the W deposition procedure from that described above. After structure 28 is inserted in reaction chamber 34 and the $WF_6$ flow is initiated, the tungsten hexafluoride reacts with silicon along exposed surface portion 26 according to the reaction.

$$2WF_6 + 3Si \rightarrow 2W + 3SiF_4$$

The silicon tetrafluoride is gaseous and leaves the immediate vicinity of surface portion 26. Accordingly, a thin tungsten layer replaces a thin silicon layer along surface portion 26. This reaction stops when the thin W layer is sufficiently thick, typically 100—400 angstroms (10—40 nm), to prevent $WF_6$ from reaching silicon in layer 16. During this time period, it is not necessary to provide $H_2$ to structure 28. However, $H_2$ may be provided during this period since the hydrogen will not have any detrimental effect. After the foregoing reaction has stopped, further W deposition to bring layer 30 to the desired thickness occurs in the manner described above by hydrogen reduction of $WF_6$.

While the invention has been described with reference to particular embodiments, this description is solely for the purpose of illustration and is not to be construed as limiting the scope of the invention claimed below. For example, a tungsten-containing species other than $WF_6$ might be employed in providing the tungsten.

## Claims

1. A semiconductor device comprising a semiconductor body which is provided with a surface which is covered by a first insulating layer on which a first conductive track is disposed which is covered by a second insulating layer, which extends also over the first insulating layer and on which a second conductive track is disposed, the second insulating layer being provided with a window through which the second conductive track contacts the first conductive track, while a layer of tungsten is present under the second conductive track, characterized in that said tungsten layer is present only on the surface of the first conductive track within the area exposed by the window in the second insulating layer.

2. A semiconductor device as claimed in Claim 1, characterized in that the first and the second insulating layer are made of silicon oxide or silicon nitride and the first conductive track is made of aluminium containing no more than 4% by weight of copper and no more than 4% by weight of silicon or of polycrystalline silicon to which a dopant may be added.

3. A method of manufacturing a semiconductor device, in which there are provided on a surface of a semiconductor body provided with a first insulating layer in order of succession a first conductive track, a second insulating layer covering said flat conductive track and said first insulating layer with a window through which a part of the first conductive track is exposed, a layer of tungsten and a second conductive layer, after which a second conductive track contacting the first conductive track via said tungsten layer in said window is etched into the second conductive layer, characterized in that the layer of tungsten is selectively deposited on the exposed part of the first conductive track.

4. A method as claimed in Claim 3, characterized in that the first and the second insulating layer are made of silicon oxide or silicon nitride and the first conductive track is made of aluminium containing no more than 4% by weight of copper and no more than 4% by weight of silicon or of polycrystalline silicon to which a dopant may be added.

5. A method as claimed in Claim 3 or 4, characterized in that tungsten is deposited from a reaction gas comprising tungsten hexafluoride and hydrogen, which is passed at a pressure of less than 650 Pa over the semiconductor body heated to a temperature of 270 to 400°C.

## Patentansprüche

1. Halbleiteranordnung mit einem Halbleiterkörper, der mit einer Oberfläche versehen ist, die durch eine erste Isolierschicht bedeckt ist, auf der eine erste Leiterspur vorgesehen ist, die durch eine zweite Isolierschicht dedeckt ist, die sich ebenfalls über die erste Isolierschicht erstreckt und auf der eine zweite Leiterspur vorgesehen ist, wobei die zweite Isolierschicht mit einem Fenster versehen ist, durch das die zweite Leiterspur die erste Leiterspur kontaktiert, während unterhalb der zweiten Leiterschicht eine Wolframschicht vorhanden ist, dadurch gekennzeichnet, daß die genannte Wolframschicht nur auf der Oberfläche der ersten Leiterspur, und zwar innerhalb des durch das Fenster in der zweiten Isolierschicht freigelassenen Gebietes vorhanden ist.

2. Halbleiteranordnung nach Anspruch 1, dadurch gekennzeichnet, daß die erste und die zweite Isolierschicht aus Siliziumoxid oder Siliziumnitrid bestehen und die erste Leiterschicht aus Aluminium hergestellt ist, das weniger als 4 Gewichtsprozent Kupfer und weniger als 4 Gewichtsprozent Silizium oder polykristallines Silizium enthält, dem ein Dotierungsmittel hinzugefügt sein kann.

3. Verfahren zum Herstellen einer Halbleiteranordnung, bei der auf einer Oberfläche eines Halbleiterkörpers, der mit einer ersten Isolierschicht versehen ist, nacheinander eine erste Leiterspur, eine die genannte erste Leiterspur und die genannte erste Isolierschicht bedeckende zweite Isolierschicht mit einem Fenster, durch das ein Teil der ersten Leiterspur freigelegt ist, eine Wolframschicht und eine zweite Leiterspur vorgesehen wird, wonach eine zweite Leiterspur, welche die erste Leiterspur über die genannte Wolframschicht in dem genannten Fenster kontaktiert, in die zweite Leiterschicht eingeätzt wird, dadurch gekennzeichnet, daß die Wolframschicht selektiv auf dem freigelegten Teil der ersten Leiterspur niedergeschlagen wird.

4. Verfahren nach Anspruch 3, dadurch gekennzeichnet, daß die erste und zweite Isolierschicht aus Siliziumoxid oder Siliziumnitrid bestehen und die erste Leiterspur aus Aluminium mit weniger als 4 Gewichtsprozent Kupfer und weniger als 4 Gewichtsprozent Silizium oder polykristallinem Silizium besteht, dem ein Dotierungsmittel hinzugefügt sein kann.

5. Verfahren nach Anspruch 3 oder 4, dadurch

EP 0 124 181 B1

gekennzeichnet, daß aus einem Reaktionsgas mit Wolframhexafluorid und Wasserstoff Wolfram niedergeschlagen wird, das bei einem Druck von weniger als 650 Pa über den auf eine Temperatur van 270 bis 400°C erhitzten Halbleiterkörper geleitet wird.

## Revendications

1. Dispositif semiconducteur comportant un corps semiconducteur présentant une surface recouverte d'une première couche isolante zur laquelle est disposée une première piste conductrice recouverte d'une deuxième couche isolante s'étendant également sur la première couche isolante et sur laquelle est disposée une deuxième piste conductrice, la deuxième couche isolante étant pourvue d'une fenètre à travers laquelle la duexième piste conductrice met en contact la première piste conductrice, une couche de tungstène étant située au-dessous de la deuxième piste conductrice, caractérisé en ce que ladite couche de tungstène ne recouvre la surface de la première piste conductrice que dans la zone mise à découvert par la fenêtre dans la deuxième couche isolante.

2. Dispositif semiconducteur selon la revendication 1, caractérisé en ce que les première et deuxième couches isolantes sont en oxyde de silicium ou en nitrure de silicium et en ce que la première piste conductrice est en aluminium contenant au maximum 4% en poids de cuivre et au maximum 4% en poids de silicium ou de silicium polycrystallin auquel peut être ajouté un dopant.

3. Procédé de fabrication d'un dispositif semiconducteur, suivant lequel, sur une surface d'un corps semiconducteur pourvu d'une première couche isolante, sont formées successivement une première piste conductrice, une deuxième couche isolante recouvrant ladite première piste conductrice et ladite première couche isolante et présentant une fenètre à travers laquelle est mise à découvert une partie de la première piste conductrice, une couche de tungstène et une deuxième couche conductrice, après quoi, dans la deuxième couche conductrice, est formée par attaque une deuxième piste conductrice mettant en contact la première piste conductrice à travers ladite couche de tungstène dans ladite fenètre, caractérisé en ce que la couche de tungstène est déposée de façon sélective sur la partie mise à découvert de la première piste conductrice.

4. Procédé selon la revendication 3, caractérisé en ce que les première et deuxième couches isolantes sont en oxyde de silicium ou en nitrure de silicium et en ce que la première piste conductrice est en aluminium contenant au maximum 4% en poids de cuivre et au maximum 4% en poids de silicium ou de silicium polycristallin auquel peut être ajouté un dopant.

5. Procédé selon la revendication 3 ou 4, caractérisé en ce que le dépôt de tungstène s'effectue à partir d'un gaz de réaction comportant de l'hexafluorure de tungstène et de l'hydrogène et qui est amené à balayer à une pression inférieure à 650 Pa le corps semiconducteur chauffé à une température comprise entre 270°C à 400°C.

7

Fig. 1a

Fig. 1b

Fig. 2a

Fig. 2b

Fig. 3a

Fig. 3b

Fig. 3c

Fig. 4a

Fig. 4b

Fig. 5a

Fig. 5b

Fig. 5c

Fig. 6a

Fig. 6b

Fig. 7